Europäisches Patentamt

European Patent Office

Office européen des brevets

(11) Veröffentlichungsnummer : **0 073 884**
**B1**

(12) **EUROPÄISCHE PATENTSCHRIFT**

(45) Veröffentlichungstag der Patentschrift :
18.09.85

(21) Anmeldenummer : 82105451.7

(22) Anmeldetag : 22.06.82

(51) Int. Cl.⁴ : **H 04 B   3/14, H 03 H   7/06**

(54) Einstellbarer Entzerrer.

(30) Priorität : 04.09.81 DE 3135001

(43) Veröffentlichungstag der Anmeldung :
16.03.83 Patentblatt 83/11

(45) Bekanntmachung des Hinweises auf die Patenterteilung : 18.09.85 Patentblatt 85/38

(84) Benannte Vertragsstaaten :
BE DE FR GB LU NL

(56) Entgegenhaltungen :
DE-B- 2 059 887
DE-B- 2 318 246
GB-A-   648 911
US-A- 3 868 604
"Taschenbuch der Hochfrequenztechnik", herausg.v.
H. Meinke und F.W.Gundlach, 3. verb.Auflage, Sprin-
ger-Verlag, Berlin, Heidelberg, New York, 1968, S.
193, Abschnitt "Resonanztransformation" mit Abb.
11.7.

(73) Patentinhaber : ANT Nachrichtentechnik GmbH
Gerberstrasse 33
D-7150 Backnang (DE)

(72) Erfinder : Heer, Roland, Dipl.-Ing.
Berliner Ring 48
D-7150 Backnang (DE)

(74) Vertreter : Schickle, Gerhard, Dipl.-Ing. et al
ANT Nachrichtentechnik GmbH Patent- und Lizenzabteilung Gerberstrasse 33
D-7150 Backnang (DE)

**Beschreibung**

Die vorliegende Erfindung betrifft ein einstellbares Entzerrernetzwerk zum Erzeugen einer frequenzabhängigen Dämpfung bzw. Verstärkung, das einen veränderbaren Widerstand und die Reihen- oder Parallelschaltung einer Induktivität und einer Kapazität enthält.

Ein derartiges Netzwerk zur Entzerrung von Dämpfungen, wie sie z. B. auf Übertragungsleitungen auftreten, ist aus der DE-PS 23 18 246 bekannt. Bei diesem Entzerrernetzwerk liegt der einstellbare Widerstand entweder parallel zu der Parallelschaltung oder in Serie zu der. Reihenschaltung der Induktivität und der Kapazität. Mit dem so geschalteten einstellbaren Widerstand können der Betrag und die Steilheit des Reaktanzverlaufs des Entzerrernetzwerks geändert werden. Es ist aber nicht möglich, in einem vorgegebenen Frequenzbereich die Steigung des Reaktanzverlaufs von positiven bis zu negativen Werten kontinuierlich einzustellen.

Der Erfindung liegt daher die Aufgabe zugrunde, ein Entzerrernetzwerk anzugeben, das mit sehr geringem Schaltungsaufwand in der Lage ist, frequenzabhängige Dämpfungs- bzw. Verstärkungscharakteristiken beliebiger Steigung zu entzerren.

Erfindungsgemäß wird die Aufgabe dadurch gelöst, daß die Kapazität durch zwei in Serie geschaltete Kondensatoren realisiert ist, wobei zu einem dieser beiden Kondensatoren der veränderbare Widerstand parallel geschaltet ist, und daß die Elemente des Netzwerks so dimensioniert sind, daß bei einem sehr großen Widerstandswert die Resonanzfrequenz des Netzwerks oberhalb der Mittenfrequenz eines gewünschten Frequenzbereichs und bei einem sehr kleinen Widerstandswert die Resonanzfrequenz des Netzwerks unterhalb der Mittenfrequenz liegt.

Anhand von in der Zeichnung dargestellten Ausführungsbeispielen soll nun die Erfindung näher erläutert werden. Es zeigen :

Figur 1 ein Entzerrernetzwerk als Reihenschaltung,

Figur 2 ein Entzerrernetzwerk als Parallelschaltung,

Figur 3 Reaktanzverläufe solcher Entzerrernetzwerke,

Figur 4 ein Entzerrernetzwerk, eingesetzt im Querzweig eines Vierpols und

Figur 5 ein Entzerrernetzwerk, eingesetzt im Rückkopplungszweig eines Verstärkers.

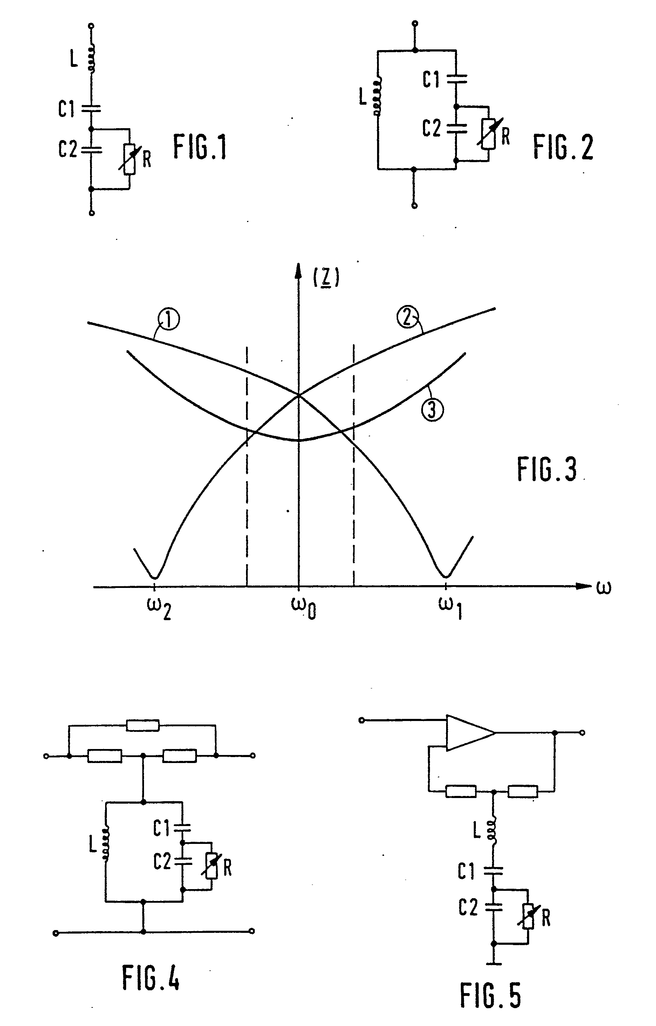

Das in der Figur 1 dargestellte Entzerrernetzwerk besteht aus der Reihenschaltung einer Induktivität L und zweier Kapazitäten C1 und C2. Parallel zu einem der beiden Kondensatoren, hier ist es der Kondensator C2, liegt ein veränderbarer Widerstand R. Eine äquivalente Schaltung hierzu zeigt die Figur 2. Parallel zu der Induktivität L sind die beiden in Serie angeordneten Kapazitäten C1 und C2 geschaltet, wobei wiederum die Kapazität C2 vom veränderbaren Widerstand R überbrückt ist.

Der veränderbare Widerstand R, der beispielsweise eine PIN-Diode oder auch ein anderes derartiges steuerbares Element sein kann, ermöglicht es, den Reaktanzverlauf des Entzerrernetzwerkes in der in Figur 3 angegebenen Weise zu verändern.

Man dimensioniert die Bauelemente des als Serien- oder Parallelschaltung aufgebauten Entzerrernetzwerkes so, daß bei einem sehr großen Wert (Leerlauf) des Widerstandes R die Resonanzfrequenz $\omega_1$ des Netzwerks oberhalb der Mittenfrequenz $\omega_0$ eines gewünschten Frequenzbereichs liegt (vergl. Reaktanzverlauf 1) und daß bei einem sehr kleinen Wert (Kurzschluß) des Widerstandes die Resonanzfrequenz $\omega_2$ des Netzwerks unterhalb der Mittenfrequenz $\omega_0$ (vergl. Reaktanzverlauf 2) liegt. Bei einem mittleren Wert des Widerstandes R ergibt sich ein Reaktanzverlauf 3, dessen Resonanzfrequenz in der Mitte des Frequenzbereichs liegt. Durch die hohe Dämpfung ergibt sich in dem gewünchten, strichliert angedeuteten Frequenzbereich ein flacher, nahezu linearer Reaktanzverlauf 3. Auch die Reaktanzverläufe 1, 2 mit positiver oder negativer Steigung sind in diesem Frequenzbereich annähernd linear.

Lediglich durch Variation eines einzigen Widerstandes kann also die Steigung des Reaktanzverlaufs des Entzerrernetzwerks kontinuierlich von positiven bis zu negativen Werten geändert werden, so daß hiermit Schräglagen von Dämpfungs- bzw. Verstärkungscharakteristiken beliebiger Steigung kompensiert werden können.

Die Figuren 4 und 5 zeigen zwei verschiedene Einsatzmöglichkeiten des oben beschriebenen Entzerrernetzwerks.

Es kann z. B., wie in Figur 4 dargestellt, den Querzweig eines Vierpols, dessen Längszweig ein Widerstandsnetzwerk enhält, bilden. Genauso kann es auch im Längszweig eines Vierpols liegen mit einem Widerstandsnetzwerk im Querzweig. Einen weiteren Anwendungsfall gibt die Figur 5 wieder, wo das Entzerrernetzwerk in den Rückkopplungszweig eines Verstärkers geschaltet ist.

**Patentanspruch**

Einstellbares Entzerrernetzwerk zum Erzeugen einer frequenzabhängigen Dämpfung bzw. Verstärkung, das einen veränderbaren Widerstand und die Reihen- oder Parallelschaltung einer Induktivität und einer Kapazität enthält, dadurch gekennzeichnet, daß die Kapazität durch zwei in Serie geschaltete Kondensatoren (C1, C2) realisiert ist, wobei zu einem dieser beiden Kondensatoren (C2) der veränderbare Widerstand (R) parallel geschaltet ist, und daß die Elemente (L, C1, C2) des Netzwerks so dimensioniert sind, daß bei einem sehr großen Widerstandswert die Resonanzfrequenz ($\omega_1$) des Netzwerks oberhalb der

Mittenfrequenz ($\omega_0$) eines gewünschten Frequenzbereichs und bei einem sehr kleinen Widerstandswert die Resonanzfrequenz ($\omega_2$) des Netzwerks unterhalb der Mittenfrequenz ($\omega_0$) liegt.

**Claim**

Adjustable equaliser network for the generation of a frequency-dependent damping or amplification, which network contains a variable resistance and the series or parallel connection of an inductance and a capacitance, characterised thereby, that the capacitance is realised by two capacitors (C1, C2) connected in series, wherein the variable resistor (R) is connected in parallel with one of both these capacitors (C2), and that the elements (L, C1, C2) of the network are so dimensioned that the resonance frequency ($\omega_1$) of the network lies above the middle frequency ($\omega_0$) of a desired frequency range in the case of a very large resistance value and the resonance frequency ($\omega_2$) of the network lies below the middle frequency ($\omega_0$) in the case of a very small resistance value.

**Revendication**

Circuit correcteur réglable, pour produire une atténuation ou, selon le cas, une amplification dépendant de la fréquence, contenant une résistance variable et un montage, série ou parallèle, d'une inductance et d'une capacité, caractérisé en ce que la capacité est réalisée par deux condensateurs (C1, C2) montés en série, la résistance variable (R) étant montée en parallèle de l'un (C2) de ces deux condensateurs, et en ce que les éléments (L, C1, C2) du circuit sont dimensionnés de façon que, pour une très grande valeur de la résistance, la fréquence de résonance ($\omega_1$) du circuit soit supérieure à la fréquence médiane ($\omega_0$) d'un domaine de fréquence désiré, et que, pour une très petite valeur de la résistance, la fréquence de résonance ($\omega_2$) du circuit soit inférieure à la fréquence médiane ($\omega_0$).

FIG.1

FIG.2

FIG.3

FIG.4

FIG.5